# EUROPEAN PATENT APPLICATION

(11) **EP 3 703 474 A1**
(43) Date of publication of application: **02.09.2020**
(21) Application number: 20156930.8
(22) Date of filing: 12.02.2020
(51) Int. Cl.: H05K 3/20, H05K 3/00, B29C 65/00, B29C 65/64, H05K 1/05, H05K 1/02

(54) **METHOD FOR PRODUCING A CIRCUIT BOARD**

(30) Priority: 26.02.2019 JP 2019032324
(71) Applicant: NHK Spring Co., Ltd., Yokohama-shi, Kanagawa 236-0004 (JP)
(72) Inventor: KAWARABAYASHI, Tomohiro, Kanagawa, 236-0004 (JP)
(74) Representative: Oppermann, Frank

(57) **Abstract**

A method for producing a circuit board includes a first step of arranging a circuit alignment jig 31 having a pierced portion 31a for receiving a circuit conductor 3a corresponding to a circuit pattern 3 on an insulating layer 7 formed on a metal substrate, a second step is inserting the circuit conductor 3a into the pierced portion 31a, and a third step is pressing the circuit conductor to the insulating layer together with the circuit alignment jig.

## Description

### BACKGROUND OF THE INVENTION

### 1. Field of the Invention

The present invention relates to a method for producing a circuit board such as a metal base circuit board capable of handling a large current.

### 2. Description of the Related Art

In recent years, need for increasing current of power devices is increased. At the same time, development requirements for metal base circuit boards with high insulation reliability is increased.

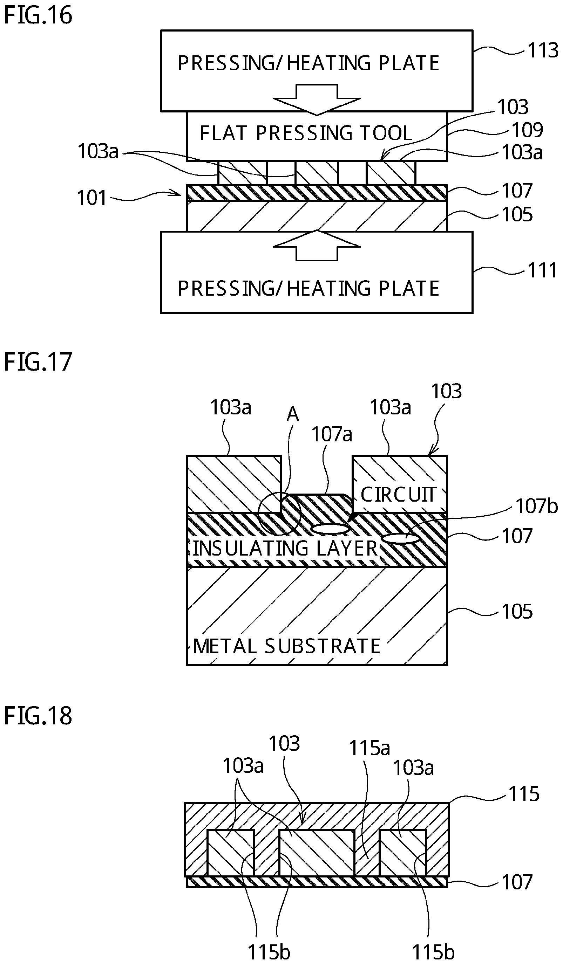

A conventional method for producing a metal base circuit board is shown in FIG.16. In a metal base circuit board 101, a circuit pattern 103 is pasted on an uncured insulating layer 107 formed on a metal substrate 105. The insulating layer 107 is heated and cured while pressing the circuit pattern 103. A press is performed by a pressing/heating plates 111 and 113 through a flat pressing tool 109.

However, the conventional method has the following problems. As shown in FIG. 17, a crack is generated in the insulating layer 107 at a portion A. The portion A is a rising part of a circuit conductor 103a of the circuit pattern 103 from the insulating layer 107. A swell 107a of the insulating layer 107 occurs between circuit conductors 103a. In the insulating layer 107, voids 107b occurs.

Therefore, it is desired to improve the bonding condition of the circuit conductor 103a to the insulating layer 107 that affects the withstand voltage. This is because the improvement of the bonding condition improves the insulation reliability of the metal base circuit board for the power device.

On the other hand, in the method for producing of FIG. 16, improvement range of a bonding condition is narrow. Improving robustness is also essential. This is because if the applied pressure is reduced, voids existing in the insulating layer 107 remain without being compressed.

For this problem, a method for producing the circuit board shown in FIG. 18 described in Patent Document 1 is proposed.

The method for producing the circuit board includes the following steps. In the first step, the circuit pattern 103 is arranged on the insulating layer 107 of the metal substrate 105. In the second step, a mold 115 is arranged. The mold 115 has a plurality of convex portions 115a. The plurality of convex portions 115a respectively correspond to the shapes of a plurality of spaces between the circuit conductors 103a. The plurality of convex portions 115a are respectively arranged in the plurality of spaces. In the third step, the mold 115 is heated under pressure. In the fourth step, the mold 115 is removed.

In such a method, it is conceivable that the positional deviation of the circuit conductor 103a is reduced. This is for applying pressure in a state where the respective convex portions 115a of the mold 115 are arranged between the respective circuit conductors 103a. It is considered that the occurrence of cracks is also suppressed. This is because the swell of the insulating layer 107 between circuit conductors 103a is suppressed by convex portions 115a of the mold 115.

However, with this method, it was difficult to set the mold 115 while maintaining the positional accuracy of the circuit conductors 103a. This is because the mold 115 is arranged for circuit conductors 103a arranged on the insulating layer 107, and the circuit conductors 103a are accommodated in concave portions 115b of the mold 115. Also, it is difficult to remove the mold 115 from the circuit conductors 103a. This is because the inside of the concave portions 115b are closed by pressing the mold 115.

### SUMARY OF THE INVENTION

The object of the present invention is to provide a method for producing a circuit board, capable of suppressing or controlling swelling of an insulating layer and suppressing occurrence of cracks

In order to accomplish the object, a method for producing a circuit board according to one aspect of the present invention includes a first step of arranging a circuit alignment jig on an insulating layer formed on a metal substrate, the circuit alignment jig having a pierced portion for receiving a circuit conductor corresponding to a circuit pattern, a second step of inserting the circuit conductor into the pierced portion, and a third step of pressing the circuit conductor to the insulating layer together with the circuit alignment jig.

According to the aspect of the present invention, the circuit alignment jig is pressed together with the circuit conductor so as to suppress or control swelling of the insulating layer and suppress cracks in the insulating layer. This improves insulation reliability. Even after the press, the pierced portion is not closed, and the circuit alignment jig is removed while maintaining the circuit position accuracy.

### BRIEF DESCRIPTION OF THE DRAWINGS

FIG. 1 is a schematic plan view of a metal base circuit board according to a first embodiment of the present invention;
FIG. 2 is a schematic cross-sectional view of the metal base circuit board according to the first embodiment;
FIG. 3 is a schematic cross-sectional view of a press apparatus according to the first embodiment;
FIGs. 4A to 4D illustrate a producing process of a semi-finished product according to the first embodiment in which, FIG.4A is a schematic cross-sectional explanatory view of a state in which a material plate used as material is arranged to the press apparatus, FIG.4B is a schematic cross-sectional explanatory view of a half-punching step, FIG.4C is a schematic cross-sectional explanatory view of a recovery step, and FIG.4D is a schematic cross-sectional explanatory view before taking out the semi-finished product from the press apparatus;
FIGs. 5A and 5B illustrate a principal part of the producing process of the semi-finished product according to the first embodiment in which FIG. 5A is an explanatory view of the half punching step and FIG. 5B is an explanatory view of the recovery step;
FIG. 6A is a plan view of the semi-finished product according to the first embodiment;
FIG. 6B is a cross-sectional view of the semi-finished product according to the first embodiment;
FIG. 7 is a conceptual explanatory view of an alignment jig arrangement step and a circuit inserting step according to the first embodiment;
FIG. 8 is a principal part explanatory view showing an isolation separation of the circuit conductor in circuit inserting step according to the first embodiment;
FIG. 9 is a conceptual explanatory view of a pressing/heating step according to the first embodiment;
FIG. 10 is a conceptual explanatory view partly illustrating a region in which the circuit conductors are pressed into the insulating layer for the circuit conductors in the pressing/heating step and the insulating layer is partly swelled;
FIG. 11 is an enlarged cross-sectional view related to FIG. 10;
FIG. 12 is a cross-sectional view of a metal base circuit board being provided with a circuit pattern with different heights or thicknesses according to a second embodiment of the present invention;
FIG. 13 is a conceptual explanatory view illustrating a pressing/heating process of a producing method according to the second embodiment;
FIG. 14 is a conceptual explanatory view illustrating an order of superposing a circuit alignment jigs in a circuit inserting step of the metal base circuit board having a circuit pattern with different heights according to a third embodiment of the present invention;
FIG. 15 is a conceptual explanatory view illustrating a pressing/heating step of a producing method according to the third embodiment
FIG. 16 is a conceptual explanatory view showing the pressing/heating step of a conventional metal base circuit board according to a related art;
FIG. 17 is a principal part enlarged cross-sectional view showing a malfunction by a pressing/heating step of the conventional metal base circuit board according to the related art; and
FIG. 18 is a cross-sectional view showing a pressing step of the circuit pattern using a mold according to the related art.

### DETAILED DESCRIPTION OF EMBODIMENTS

Embodiments accomplishes the object to suppress or control swelling of an insulating layer and suppress cracks to improve reliability.

A method for producing a circuit board according to the embodiments of the present invention includes a first step, a second step, and a third step. The first step is a step of arranging a circuit alignment jig on an insulating layer formed on a metal substrate, the circuit alignment jig having a pierced portion for receiving a circuit conductor corresponding to a circuit pattern. The second step is a step of inserting the circuit conductor into the pierced portion. The third step is a step of pressing the circuit conductor to the insulating layer together with the circuit alignment jig.

A thickness of the circuit alignment jig is thinner than a thickness of the circuit conductor.

The pierced portion has an enlarged portion on the insulating layer side, the enlarged portion gradually increasing a contour of the pierced portion toward the insulating layer, and the third step partly swells the insulating layer into the enlarged portion during the pressing.

The circuit alignment jig is subjected to surface treatment to secure releasability from the insulating layer.

The second step arranges a semi-finished product being plate material that positions and holds the circuit conductor corresponding to the circuit pattern is onto the circuit alignment jig, and extrudes the circuit conductor from the semi-finished product to conduct the inserting of the circuit conductor into the pierced portion.

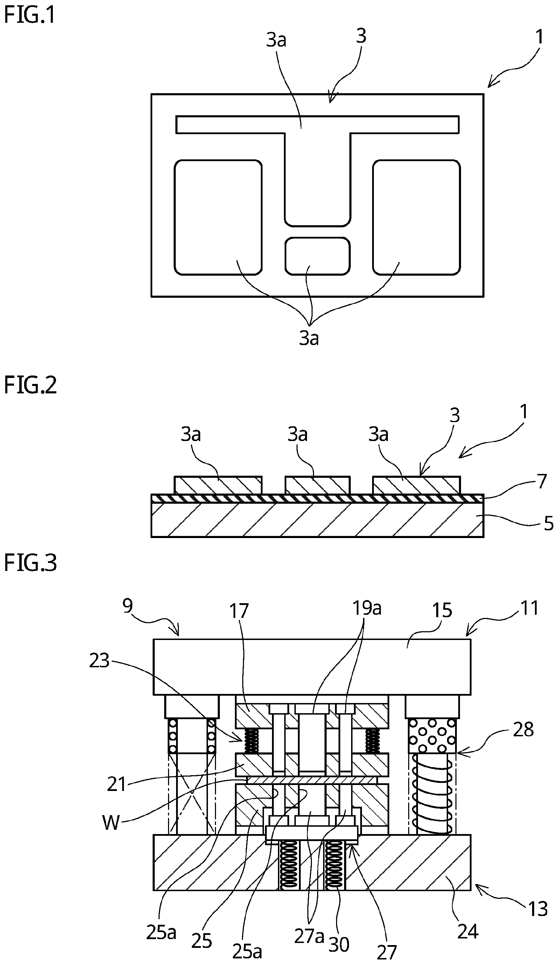

FIG. 1 is a schematic plan view of a metal base circuit board. FIG. 2 is a schematic cross-sectional view of the metal base circuit board using a flat metal substrate.

A metal base circuit board 1 shown in FIGs. 1 and 2 includes a thick circuit pattern 3 according to a large electric current. The metal base circuit board 1 includes a circuit pattern 3, a flat metal substrate 5 and an insulating layer 7. The circuit pattern 3 is formed on the flat metal substrate 5 through the insulating layer 7 so that the insulating layer 7 is interposed between the circuit pattern 3 and the flat metal substrate 5.

A circuit pattern 3 is made of, for example, copper. Namely, the circuit pattern 3 is formed of a circuit copper material. The copper material for a circuit is a thick copper pattern having a thickness 0.5 mm or more. The thickness of the circuit pattern3 may be optional and may be less than 0.5 mm.

The circuit pattern 3 includes a plurality of electrically independent circuit conductors 3a. The configuration of the plurality of circuit conductors 3a is formed according to the required characteristics of the circuit pattern 3. The number and shapes of conductors 3a are optional according to requirements. The number of the circuit conductors 3a according to the embodiment is four, however may be one, two, three or five or more.

The insulating layer 7 serves to electrically insulate the circuit pattern 3 from the metal substrate 5. In addition, the insulating layer 7 also serves as an adhesive that bonds the circuit pattern 3 and the metal substrate 5 together. Therefore, resin is generally used for the insulating layer 7. Furthermore, the insulating layer 7 is required to have high heat resistance with respect to a high exothermic property of elements mounted on the circuit pattern 3. The insulating layer 7 is required to have a high heat transfer property for transferring heat generated by the element to the metal substrate 5. Therefore, the insulating layer 7 preferably further contains inorganic fillers.

As a matrix resin of the insulating layer 7, one or a combination of two or more of resins are suitably used from epoxy resins such as bisphenol A type epoxy resin, bisphenol F type epoxy resin, and triazine type epoxy resin; and cyanate resins such as bisphenol E type cyanate resin, bisphenol A type cyanate resin, and novolak type cyanate resin.

As the inorganic filler contained in the insulating layer 7, a material preferably has excellent electrical insulation and high thermal conductivity. For the inorganic filler, one or more materials are suitably used from among alumina, silica, aluminum nitride, boron nitride, silicon nitride, magnesium oxide and the like.

The filling rate of the inorganic filler in the insulating layer 7 is appropriately set according to the type of the inorganic filler. For example, the filling rate is preferably set to 85% by volume or less, more preferably set to 30 to 85% by volume relative to the total volume of the matrix resin contained in the insulating layer 7.

The insulating layer 7 may further contain, for example, a coupling agent, a dispersant, and the like in addition to the matrix resin and the inorganic filler described above.

A semi-cured insulating sheet may be used as the insulating layer 7.

The metal substrate 5 is made of, for example, a single metal or an alloy. As a material of the metal substrate 5, for example, aluminum, iron, copper, an aluminum alloy, or stainless steel are used. The metal substrate 5 may contain nonmetal such as carbon. For example, the metal substrate 5 may contain aluminum combined with carbon. The metal substrate 5 is a single layer structure. The metal substrate 5 may have a multilayer structure.

The metal substrate 5 has a high thermal conductivity. For example, the metal substrate 5 has the thermal conductivity set in a range of 370 to 400 W · m⁻¹ · K⁻¹ in the case of the copper-based substrate, 190 to 220 W · m⁻¹ · K⁻¹ in the case of the aluminum-based substrate, and 60 to 80 W · m⁻¹ · K⁻¹ in the case of the iron-based substrate.

The metal substrate 5 may have flexibility or may not have flexibility. The thickness of the metal substrate 5 is set in the range of, for example, about 0.2 to 5 mm.

The metal base circuit board 1 may also be configured to have a metal substrate formed into a heat sink shape.

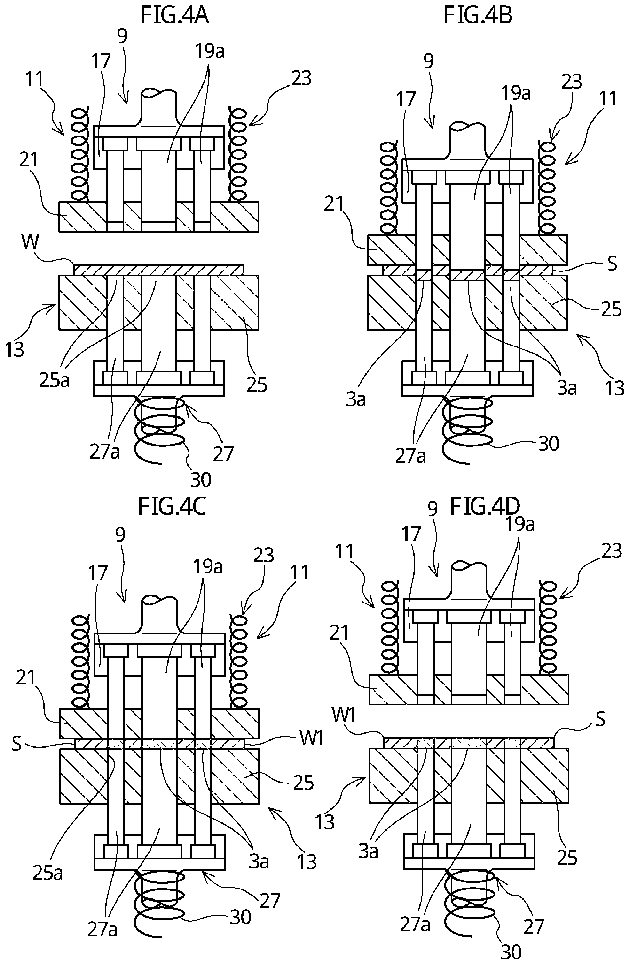

FIG. 3 is a schematic cross-sectional view of a press apparatus. FIGs. 4A to D illustrate a producing process of a semi-finished product in which FIG.4A is a schematic cross-sectional explanatory view of a state in which a material plate used as material is arranged to the press apparatus, FIG.4B is a schematic cross-sectional explanatory view of a half-punching step, FIG.4C is a schematic cross-sectional explanatory diagram of a recovery step, and FIG.4D is a schematic cross-sectional explanatory view just before taking out the semi-finished product from the press apparatus.

In the method for producing the metal base circuit board according to the embodiment of the present invention, a semi-finished product W1 is used. The semi-finished product W1 is a plate material that positions and holds the circuit conductors 3a corresponding to the circuit pattern 3. The press apparatus of FIG. 3 is used for the producing method of the semi-finished product W1. The producing method includes a half-punch step S1 and a recovery step S2. A scrap S is a portion that is left after punching a product from a material plate. In the embodiment, the scrap S is a portion of the material plate not to be the circuit conductors 3a. Namely, in the semi-finished product W1 described below, the outer periphery of each circuit conductor 3a is entirely separated from and fitted to the scrap S, or is partially connected and fitted to the scrap S. The scrap S in the semi-finished product W1 is also the portion of the material plate not to be the circuit conductors 3a other than portions to be the circuit conductors 3a. The portion not to be the circuit conductors 3a remains as the scrap S after the circuit conductors 3a are separated in a circuit inserting step S4 described later.

The producing method of the metal base circuit board 1 includes an alignment jig arranging step S3 as a first step, the circuit inserting step S4 as a second step, a pressing/heating step S5 as a third step, and an alignment jig removing step as a fourth step.

As shown in FIG. 3, the press apparatus 9 includes an upper mold 11 and a lower mold 13 as molds.

The upper mold 11 is attached to a pressing mechanism side (not shown). The upper mold 11 is lowered by hydraulic pressure or mechanical press to generate a pressing force.

The upper mold 11 includes a punch plate 17 and a set plate 15. The punch plate 17 is attached to the set plate 15. A plurality of types of punches 19a are supported on the punch plate 17. The punches 19a are provided so as to correspond to the circuit conductors3a of the circuit pattern 3 (FIG. 1). A stripper plate 21 is arranged on a tip side of the punches 19a. The stripper plate 21 includes a stripper unit 23 and a sub guide post (not shown) so that the stripper plate 21 is guided by the sub guide post. The stripper plate 21 is retractable toward the punch plate 17 while being guided. The retracting movement of the stripper plate 21 is performed against a biasing force of a coil spring, a gas cushion, a hydraulic device, a pneumatic device, or the like provided in the stripper unit 23.

The lower mold 13 includes a die plate 25 and a knockout 27 shown in FIG. 4.

A set plate 24 is fixed to a base plate (not shown). A guide post 28 connects the set plate 24 of the lower mold 13 and the set plate 15 of the upper mold 11.

The die plate 25 is supported by a base plate (not shown). The die plate 25 includes a die 25a corresponding to the punch 19a. The die plate 25 is provided with pilot pins (not shown) for fitting pilot holes of the material plate.

The knockout 27 is supported movably up and down on the base plate. The knockout 27 includes knockout pins 27a that slidably fit to holes of the die 25a.

In the knockout 27, the upper end of each knockout pin 27a is normally flush with the upper surface of the die plate 25. A gap is defined between the knockout 27 and the set plate 24 to allow the material plate to be partially blanked, such as half blanking. A coil spring 30 is interposed between the base plate and the knockout 27 to generate counter pressure.

The knockout 27 is supported by the coil spring 30 on the base plate before the material plate is partially punched or blanked. The upper ends of the knockout pins 27a are normally flush with the upper surface of the die plate 25.

On the base plate, the press apparatus 9 has a hydraulic device, a pneumatic device, or the like that pushes up the knockout 27 after the material plate is partially punched or blanked.

As shown in FIGs. 3 and 4B, in the half punching step S1, the circuit pattern 3 having the plurality of circuit conductors 3a is partially punched or blanked from the copper plate material W as the material plate.

For example, as shown in FIG. 4A, the copper plate material W which is flat and rectangular is supplied between the upper mold 11 and the lower mold 13 as the material plate. The left-right direction in FIG. 4A is the X-direction, and the direction perpendicular to the X-direction is the Y-direction. In particular, the copper plate material W is carried in an area between the upper die 11 and the lower die 13 in the X-direction by the carrying jig. The copper plate material W may be carried in the area from the Y-direction. The copper plate material W may be continuously supplied between the upper die 11 and the lower die 13 as a continuous material plate.

In the copper plate W, the pilot holes are formed in advance. An outer shape of the copper plate material W is precisely set positionally relative to the pilot hole. Namely, the copper plate material W has the positional accuracy of the outer shape with respect to the pilot hole. Therefore, the positional relationship between the outer shape of the copper plate material W and the circuit pattern 3 is secured with reference to the pilot hole. As shown in FIG. 4B, the upper die 11 is lowered in the partially blanking step S1, and the stripper plate 21 is elastically contacted on the copper plate material W. Then, the punch 19a is further lowered. The copper plate material W is partially punched or blanked while receiving the counter pressure at locations corresponding to the circuit conductors 3a of the circuit pattern 3. The counter pressure is applied by the coil spring 30 via the knockout pin 27a. Since the portions corresponding to the circuit conductors 3a are subjected to partially blanking while receiving the counter pressure, the partially blanked circuit conductors 3a are prevented from being deteriorated in flatness.

The portions corresponding to the circuit conductors 3a partially enter into the die 25a and the scrap S remains between the stripper plate 21 and the die plate 25.

As shown in FIG. 4C, in the recovery step S2, the knockout 27 is driven to move to a flush position after the copper plate material W is partially punched or blanked. The flush position a position of the upper end of each knockout pin 27a is flush with the upper surface of the die plate 25. The drive of the knockout 27 is performed by a hydraulic apparatus, a pneumatic apparatus, or the like.

The portions corresponding to the circuit conductors3a are partially punched or blanked. According to the embodiment, the partially blanking is half blanking. The partially blanked portions corresponding to the circuit conductors 3a are pressed and returned into the scrap S from a partially blanked position in the recovery step S2. According to the embodiment, the partially blanked portions are pressed simultaneously. By this return, the flat plate-like semi-finished product W1 is completed.

Thereafter, as shown in FIG. 4D, the upper mold 11 is raised to allow the semi-finished product W1 to be taken out from the press apparatus 9 by the transfer jig. The semi-finished product W1 taken out from the press apparatus 9 is separated from a mass production line for completing the metal base circuit board 1 and stored. The mass production line is for consistently completing the metal-based circuit board 1. In addition, the pressing and returning of the circuit conductors 3 after partially blanking of the copper plate material W may be performed by another pressing apparatus including an upper and lower mold to press the partially blanked plate material W with a flat surface.

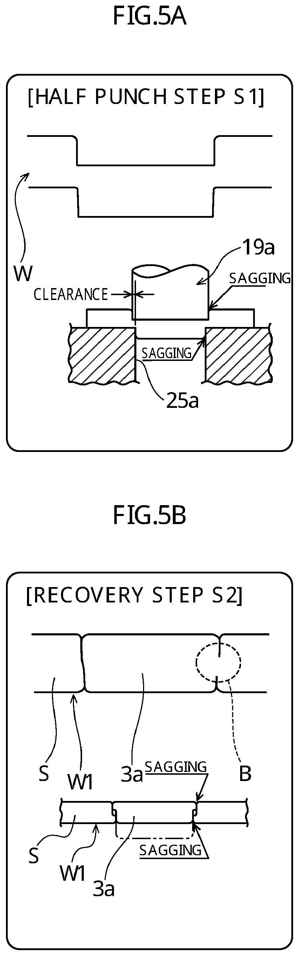

FIGs. 5A and 5B partially illustrate the plate material W and a periphery thereof in the producing process of the semi-finished product in which FIG. 5A is an explanatory view of the partially blanking step and FIG. 5B is an explanatory view of the recovery step.

In FIG. 5A, a diameter of the punch 19a for partially blanking the copper plate material W is slightly larger than a diameter of the die 25a. The punch 19a has a negative clearance with respect to the die 25a.

In the partially blanking step S1, the punch 19a is pressed into the plate material W toward the die 25a. In the partially blanking step S1, the pressing amount is set in the range of 60 to 90% of a plate thickness of the plate material W.

As shown in FIG. 5B, in the recovery step S2, the circuit conductors 3a in the partially blanked state are returned from the partially blanked positions by reversely pressing. Accordingly, the outer periphery of each circuit conductor 3a is entirely cut from the scrap S in the flat-shaped semi-finished product W1, or partially cut from the scrap S to be partially integrally connected to the scrap S.

According to the embodiment, the outer periphery of each circuit conductor 3a is partially cut from the scrap S. In FIG. 5B, the outer periphery of the circuit conductor 3a is partially connected to the scrap S at the portion B.

If the thickness of the circuit conductors 3a (copper plate material W) exceeds 0.5 mm, the outer periphery of each circuit conductor 3a may be entirely separated from the scrap S in the recovery step S2.

In this case, each circuit conductor 3a has a portion within an interspace between the circuit conductor 3a and the scrap S, the portion having a cross-sectional shape that causes the circuit conductor 3a to be fitted and held in the scrap S. At the same time, the circuit conductors 3a each include sagging on the upper and lower surfaces of the circuit conductor 3a.

As described above, the following settings are made in advance before or in the recovery step S2. The first setting is to set whether or not the circuit conductors 3a are entirely separated from the scrap S. The second setting is to set the cross-sectional shape suitable for holding the fitting state of the entirely separated circuit conductors 3a to the scrap S if each conductor 3a is entirely separated from the scrap S. These settings are controlled by the pressing amount in the partially blanked process in the partially blanked step S1. If the plate thickness of the circuit conductors 3a is 0.5mm or more, the pressing amount is preferably set in the range of 60 to 90% of the plate thickness of the conductors 3a to entirely separate the conductors 3a from the scrap S. Even if the conductors 3a are entirely separated, the scrap S having the thickness 0.5mm or more relatively easily holds the separated conductors 3a fitted to corresponding holes of the scrap S. If the plate thickness of the circuit conductors 3a (copper plate material W) is 0.5mm or less, the scrap S may not hold the separated circuit conductors 3a fitted to the corresponding holes of the scrap S so that the circuit conductors 3a may drop off from the scrap S. In this case, the pressing amount of the partially blanking process is reduced. Thus, the pressing amount in the partially blanking process is set within a range of 40 to 80% of the plate thickness so as not to completely separate the conductors 3a. If the pressing amount is reduced as mentioned above, the circuit conductors 3a are hard to be entirely separated from the scrap S during the reversely pressing.

As the cross-sectional shape in the case of separating the circuit conductors 3a from the scrap S, for example, a concavo-convex shape in a radial direction is applicable by a vertical punching method. This cross-sectional shape is controlled by the depth of the partially blanking process. According to the cross-sectional shape, the circuit conductors 3a are held in the fitting state with respect to the scrap S.

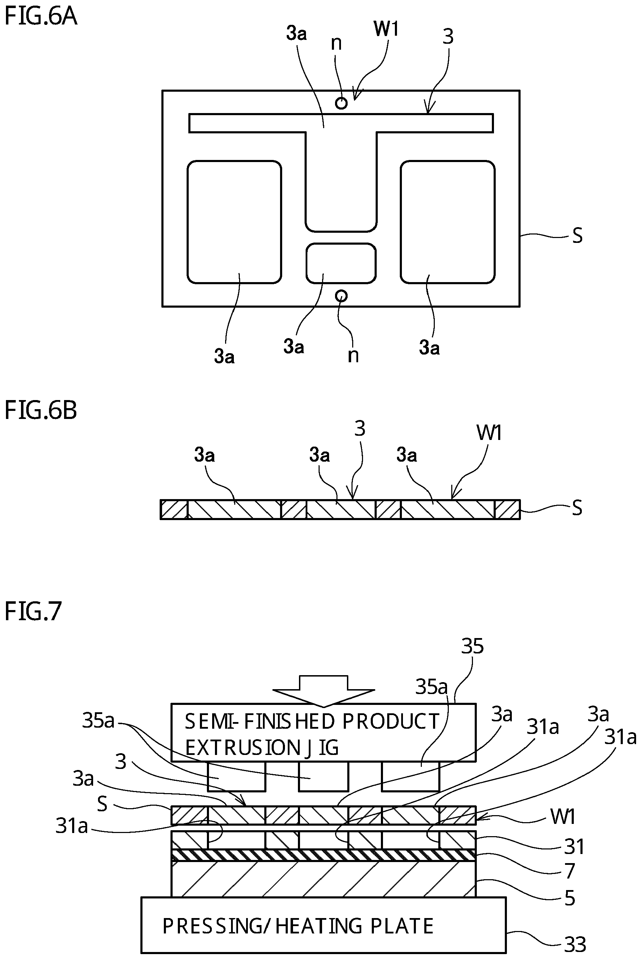

FIG. 6A is a plan view of the semi-finished product. FIG. 6B is a cross-sectional view of the semi-finished product.

As shown in FIGs. 6A and 6B, the semi-finished product W1 forms the flat plate having the circuit conductors 3a. The circuit conductors 3a are positioned so as to correspond to the circuit pattern 3.

Namely, the portions corresponding to the circuit conductors 3a are returned to the partially blanking positions in the scrap S and are located within the thickness. The circuit conductors 3a are, therefore, fitted and positioned within the scrap S so that the semi-finished product W1 as a whole is flat. The scrap S on which the circuit conductors 3a are positioned has substantially the same shape as the original copper plate material. The scrap S additionally includes, for example, two pilot holes n. The pilot holes n are formed in advance before the partially blanked process. The number and locations of the pilot holes n are arbitrarily selected.

In the semi-finished product W1, the outer periphery of each circuit conductor 3a is entirely cut off from the scrap S or partially integrated with the scrap S. Each circuit conductor 3a of the set of circuit conductors 3a to be the circuit pattern 3 is not surrounded by other circuit conductors 3a so as to include part adjacent to the outer periphery of the semi-finished product W1 without interposition of the other conductors 3a in the radial direction in the plan view. However, a set of circuit conductors may have a circuit conductor surrounded by other circuit conductors so as not to include part adjacent to the outer periphery of the semi-finished product W1 without interposition of the other conductors 3a in the radial direction in the plan view.

If the outer periphery of each circuit conductor 3a is entirely separated from the scrap S, the cross-sectional shape between the scrap S and the circuit conductor 3a is a cross-sectional shape that holds the fitting state of the circuit conductor 3a to the scrap S. This cross-sectional shape is formed as described above.

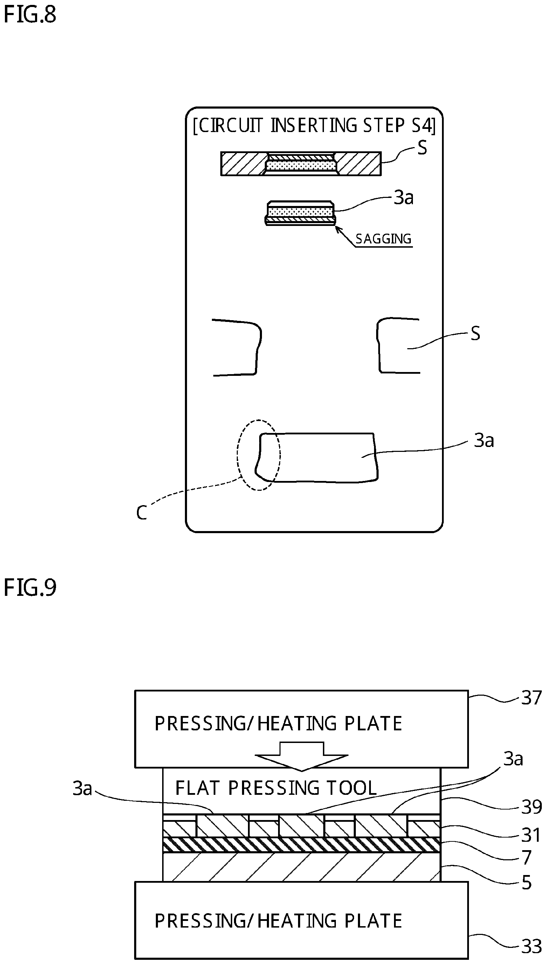

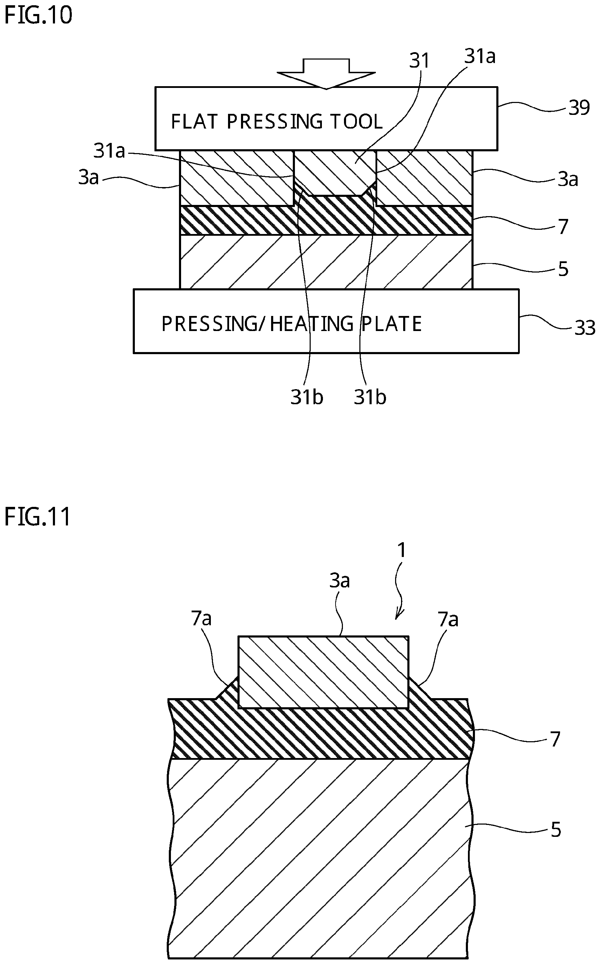

FIG. 7 is a conceptual explanatory view of an alignment jig arrangement step and circuit conductors inserting step. FIG. 8 is an explanatory view partly illustrating a blank and the scrap of the circuit conductor in circuit inserting step. FIG. 9 is a conceptual explanatory view of a pressing/heating step. FIG. 10 is a conceptual explanatory view partly illustrating a region in which the circuit conductors are pressed into the insulating layer of circuit conductors in the pressing/heating step and the insulating layer is partly swelled. FIG. 11 is an enlarged cross-sectional view related to FIG. 10.

As shown in FIGs. 7 to 9, the method of producing the metal base circuit board 1 according to the embodiment of the present invention (producing method) includes the alignment jig arranging step S3, the circuit inserting step S4, the pressing/heating step 35,
the alignment jig removing step as described above.

As shown in FIG. 7, in the alignment jig arrangement step S3, the metal substrate 5 is positioned and set on the pressing/heating plate 33. A circuit alignment jig 31 is positioned on the insulating layer 7 formed on the metal substrate 5 by a positioning jig.

The circuit alignment jig 31 is made of metal or the like. The circuit alignment jig 31 is subjected to surface treatment with fluororesin or the like to ensure releasability from the insulating layer 7. The surface treatment is a film treatment or the like. The surface treatment is conducted over upper and lower surfaces, a side peripheral surface, and pierced portions 31a of the circuit alignment jig 31.

The pierced portions 31a are arranged and formed corresponding to the circuit pattern 3. Each pierced portion 31a is a hole for receiving the corresponding circuit conductor 3a of the circuit pattern 3. The pierced portions 31a have the same pattern as the circuit pattern 3.

Each pierced portion 31a is accurately formed so as to be slightly larger than the corresponding circuit conductor 3a. The pierced portion 31a is configured so that the insulating agent of the insulating layer 7 does not enter between the pierced portion 31a and the circuit conductor 3a fitted thereto in the pressing/heating step S5 which is described later. However, a larger gap may be set between an inner periphery of the pierced portion 31a and an outer periphery of the circuit conductor 3a. The larger gap may receive the insulating agent of the insulating layer 7 that covers the side peripheral portion of the circuit conductor 3a as a layer between the circuit conductor 3a and the inner periphery of the pierced portion 31a.

The thickness of the circuit alignment jig 31 is set to be thinner than the thickness of the circuit conductors 3a. This difference in thickness corresponds to the embedding amount of the circuit conductors 3a with respect to the insulating layer 7. The difference in thickness is about 0 to 25% of the thickness of the insulating layer 7. However, the thickness of the circuit alignment jig 31 may be the same as the thickness of the circuit conductors 3a.

As shown in FIG. 7, in the circuit inserting step S4, the semi-finished product W1 is placed onto the circuit alignment jig 31. The semi-finished product W1 is the plate material for positioning and holding the circuit conductors 3a corresponding to the circuit pattern 3 as described above. Then, the circuit conductors 3a are extruded from the semi-finished product W1 and inserted into the pierced portion 31a.

In this circuit inserting step S4, an extrusion jig 35 is used. The extrusion jig 35 has punches 35a corresponding to the circuit pattern 3. The sizes of the outer shapes of the punches 35a are slightly smaller than the corresponding pierced portions 31a of the circuit alignment jig 31.

The semi-finished product W1 is carried in by a positioning jig. The semi-finished product W1 is accurately positioned and arranged onto the circuit alignment jig 31. The positioning of the semi-finished product W1 with respect to the circuit alignment jig 31 may be conducted by bring the surfaces of the semi-finished product and the circuit alignment jig 31 into contact with each other. The positioning may be performed while keeping a gap between the circuit alignment jig 31 and the semi-finished product W1. The upper surface of the circuit alignment jig 31 is preferably chamfered or tapered for insertion of the circuit conductors 3a. If keeping the gap between the circuit alignment jig 31 and the semi-finished product W1, the gap is set to about a half of the thickness of the circuit conductor 3a.

At this position, the punches 35a are lowered to push the circuit conductors 3a out of the scrap S. The circuit conductors 3a are easily separated from the scrap S by this extrusion. The circuit conductors 3a are inserted into the pierced portions 31a, respectively. In this inserted state, the circuit pattern 3 is transferred onto the insulating layer 7 which is formed on the metal substrate 5 in conformity with the circuit pattern 3. Each circuit conductor 3a extruded in this way has sags at the both edges of the upper and lower sides, as shown in a part C of FIG 8. The overall flatness of the circuit conductors 3a are also maintained.

If the semi-finished product W1 is positioned over the circuit alignment jig 31 while keeping the gap, the circuit conductors 3a are guided with the scrap S by a half of the thickness of each circuit conductor 3a during the inserting operation. Thus, the circuit conductors 3a are inserted into the pierced portions 31a while the positional accuracy is maintained. In addition, the gap may be set freely as long as the circuit conductors 3a are transferred while maintaining the positional accuracy.

The extrusion jig 35 moves up after the circuit conductors 3a are inserted into the pierced portions 31a. Then, the scrap S from which the circuit conductors 3a are pushed out is carried from the circuit alignment jig 31 by the positioning jig. At this time, each punch 35a of the extrusion jig 35 incorporates an ejector pin so that the circuit conductors 3a are not pulled up from the circuit alignment jig 31.

As shown in FIG. 9, a pressing/heating process is performed in the pressing/heating step S5. Namely, the circuit conductors 3a are pressed together with the circuit alignment jig 31 by the pressing/heating process. In this pressing/heating step S5, a pressing/heating plate 37 and a flat pressing tool 39 are used in place of the extrusion jig 35 of FIG.7.

In the embodiment, the thickness of the circuit alignment jig 31 is set to be thinner than the thickness of the circuit conductors 3a. Accordingly, the flat pressing tool 39 contacts the upper surfaces of the circuit conductors 3a at the beginning of the pressing while the flat pressing tool 39 forms a gap with respect to the upper surface of the circuit alignment jig 31.

When the pressing/heating plate 37 is lowered, the upper surface of the circuit conductors 3a are pressed by the flat pressing tool 39. The circuit conductors 3a are, therefore, lowered or descends in the pierced portions 31a by the pressing. The lower surface sides of the circuit conductors 3a are pushed into the insulating layer 7 by the descending of the circuit conductors 3a.

Subsequently descending the pressing/heating plate 37, the upper surfaces of the circuit conductors 3a become flush with the upper surface of the circuit alignment jig 31. Thus, the upper surfaces of the circuit conductors 3a and the circuit alignment jig 31 are both pressed by the predetermined pressure.

By this pressing, the metal substrate 5, the insulating layer 7, the circuit conductors 3a and the circuit alignment jig 31 are pressed between the pressing/heating plates 33 and 37. At the same time, the insulating layer 7 is heated and cured.

Then, in the alignment jig removing step, the pressing/heating plate 37 and the flat pressing tool 39 are raised. The circuit alignment jig 31 is removed from the insulating layer 7 and the circuit conductors 3a by the positioning jig. At this time, the circuit alignment jig 31 is easily removed from the insulating layer 7 and the circuit conductors 3a due to the surface treatment.

Since the surface of the circuit alignment jig 31 facing the flat pressing tool 39 does not come into contact with the insulating layer 7, the surface of the circuit alignment jig 31 may not be subjected to surface treatment. In this case, the circuit alignment jig 31 is firstly subjected to the surface treatment over the entire surface. Next, the surface of the circuit alignment jig 31 facing the flat pressing tool 39 is ground. By this grinding, the circuit alignment jig 31 is reduced the jig thickness while the surface of the circuit alignment jig 31 facing the flat pressing tool 39 remains the metal surface. The pierced portions 31a are definitely subjected to a surface treatment.

By the removing of the circuit alignment jig 31, a metal base circuit board is produced. The produced metal base circuit board is taken out from the pressing/heating plate 33 by a jig for unloading.

In this case, slight clearances are preferably respectively defined between the pierced portions 31a of the circuit alignment jig 31 and the circuit conductors 3a unless the slight clearances affect the position accuracy of the circuit conductors 3a. In particular, each clearance is formed between the inner periphery of the pierced portion 31a and the outer periphery of the circuit conductor 3a. The clearance extends from the lower surface facing the insulating layer 7 and the upper surface facing the flat pressing tool 39 in the thickness direction of the circuit alignment jig 31. The clearance is preferably maintained even when the circuit alignment jig 31 and the circuit conductors 3a are thermally expanded by the heating.

By this clearance, the exhaustibility of gas generated in the pressing/heating step S5.

In the circuit inserting step S4, the circuit conductors 3a may be individually prepared and inserted into the pierced portions 31a of the circuit alignment jig 31. In this case, the circuit inserting step S4 does not use the semi-finished product W1 and the extrusion jig 35. In the circuit inserting step S4, the circuit conductors 3a are individually inserted into the pierced portions 31a of the circuit alignment jig 31 by the inserting jig. Subsequently, the pressing/heating step S5 of FIG. 9 is performed.

FIG. 10 shows a form of embedding the circuit conductors 3a in the insulating layer 7.

The pierced portion 31a of the embodiment has a chamfered portion 31b. The chamfered portion 31b enlarges the contour of the pierced portion 31a on the insulating layer 7 side with respect to the side surface of the circuit conductor 3a. Namely, the chamfered portion 31b is an enlarged portion on the insulating layer 7 side. The enlarged portion gradually increases the contour of the pierced portion 31a toward the insulating layer 7. The size of the chamfered portion 31b is dependent on the thickness of the circuit conductor 3a. If the thickness of the circuit conductor 3a is 0.5mm, the size of the chamfer 31b is about 0 to 50% of the thickness of the circuit conductor 3a. The pressing/heating step S5 partly swells the insulating layer into the enlarged portion during the pressing.

In addition, the enlarged portion is required to control the swelling of the insulating layer 7. The enlarged portion is not necessarily chamfered. The enlarged portion may be formed into various shapes such as a rounded shape. Moreover, the chamfered portion 31b as an enlarged portion may be omitted.

When the lower part of the circuit conductors 3a are embedded in the insulating layer 7 as described above, therefore, part of the insulating layer 7 is displaced by the circuit conductors 3a. Then, the part of the insulating layer 7 swells on the lower surface of the circuit alignment jig 31 and into the chamfered portions 31b. As a result, the chamfered portions 31b are filled with the insulating layer 7 as shown in FIG.10. Thus, the swelling of the insulating layer 7 is controlled by the lower surface of the circuit alignment jig 31 and the chamfered portions 31b.

Then, as shown in FIG. 11, the circuit conductors 3a of the produced metal base circuit board 1 are embedded in the insulating layer 7 on the lower surface side. A fillet-shaped portion 7a is formed around each circuit conductor 3a at the swelled portion of the insulating layer 7.

The embedded amount of the circuit conductors 3a in the insulating layer 7 is 0 to 25% of the thickness of the insulating layer 7. The height of the fillet-shaped portions 7a from the surface of the insulating layer 7 is about 0 to 50% of the thickness of the circuit conductors 3a.

According to the embodiment of the present invention, the method for producing a circuit board includes the alignment jig arranging step S3, the circuit inserting step S4, the pressing/heating step S5, and the alignment jig removing step. In the alignment jig arranging step S3, the circuit alignment jig 31 is arranged on the insulating layer 7 formed on the metal substrate 5, the circuit alignment jig 31 having the pierced portion 31a for inserting corresponding to the circuit pattern 3. In the circuit inserting step S4, the semi-finished product W1 is arranged onto the circuit alignment jig 31. The semi-finished product W1 is the plate material that positions and holds the circuit conductors 3a corresponding to the circuit pattern 3. The circuit conductors 3a are extruded from the semi-finished product W1 to conduct the inserting of the circuit conductors 3a into the pierced portions 31a. In the pressing/heating step S5, the circuit conductors 3a are pressed and heated together with the circuit alignment jig 31 between the pressing/heating plates 33 and 37 via the flat pressing tool 39. The alignment jig removing step removes the circuit alignment jig 31.

Therefore, the upper surface of the insulating layer 7 is pressed by the lower surface of the circuit alignment jig 31 around the circuit conductor 3a. The upper surface of the insulating layer 7 is a uniform flat surface. Therefore, the thickness of the insulating layer 7 is made constant.

The circuit conductors 3a are aligned by the circuit alignment jig 31. In the circuit pattern 3 formed on the metal substrate 5, the respective circuit conductors 3a are aligned relatively to each other and held in the aligned state. Accordingly, the method of the embodiment obtains the accurate circuit pattern 3 having no deviation as designed.

The method of the embodiment prevents the insulating layer 7 from irregularly swelling between the circuit conductors 3a. The method suppresses cracks in the insulating layer 7. Further, the method compresses the insulating layer 7 to suppress voids existing in the insulating layer 7, thereby to improve insulation reliability. The insulating layer 7 is pressed by the lower surface of the circuit conductors 3a and the circuit alignment jig 31. This improves the adhesion at the interfaces between the circuit conductors 3a and the insulating layer 7, so that new voids are prevented from being generated in the insulating layer 7.

The thickness of the circuit alignment jig 31 is set thinner than the thickness of the circuit conductors 3a.

Accordingly, the lower surface side or lower portion of each circuit conductor 3a of the produced metal base circuit board 1 is embedded in the insulating layer 7. This embedding improves the peel strength of the metal base circuit board 1.

Moreover, the pierced portion 31a has the chamfered portion 31b as an enlarged portion in which the contour of the pierced portion 31a is gradually enlarged toward the insulating layer 7. In the pressing/heating step S5, part of the insulating layer 7 is raised or swelled within the chamfered portion 31b during the pressing.

Therefore, the fillet-shaped portion 7a is formed at the swelled portion along the side surface of each circuit conductor 3a. With this fillet-shaped portion 7a, the peel strength of the metal base circuit board 1 is further improved. Further, the fillet-shaped portion 7a swells along the side surface of each circuit conductor 3a to improve heat dissipation.

The method respectively inserts the circuit conductors 3a into the pieced portions 31a by using the semi-finished product W1 to improve workability of the inserting.

The circuit alignment jig 31 is subjected to surface treatment such as film treatment with fluororesin for securing the releasability from the circuit conductors 3a and the insulating layer 7.

Therefore, the circuit alignment jig 31 is easily removed from the circuit conductors 3a and the insulating layer 7 of the metal base circuit board 1.

In the circuit inserting step S4, the semi-finished product W1 that positions and holds the circuit conductors 3a corresponding to the circuit pattern 3 is arranged onto the circuit alignment jig 31. In the circuit inserting step S4, the circuit conductors 3a are extruded from the semi-finished product W1 to be inserted into the pierced portion 31a of the circuit alignment jig 31.

Therefore, workability is improved as compared with the case that the circuit conductors 3a are individually inserted into the pierced portions 31a.

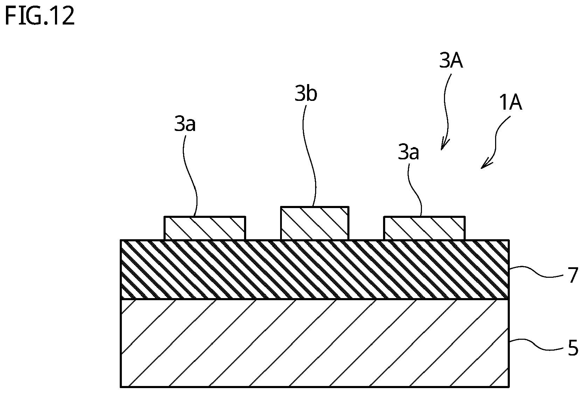

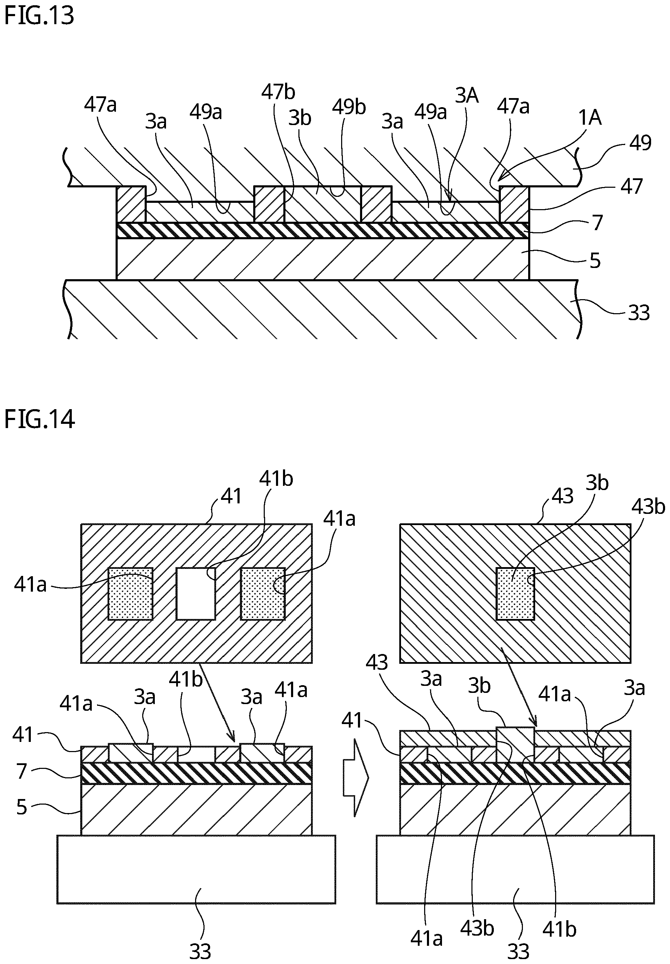

FIG. 12 is a cross-sectional view of a metal base circuit board being provided with a circuit pattern with different heights or thicknesses according to the second embodiment of the present invention. FIG. 13 is a conceptual explanatory view showing a pressing/heating process of the producing method according to the second embodiment.

The second embodiment relates to a method for producing the metal base circuit board being provided with the circuit pattern including circuits having different heights or thicknesses.

In the metal base circuit board 1A of FIG. 12, the heights of the circuit conductors 3a and 3b of the circuit pattern 3A are different from each other. The difference amount between the heights of the circuit conductors3a and 3b may be freely set according to requirements.

In this case, two types of the circuit conductors 3a and 3b are produced in the same way as the first embodiment for the semi-finished product. Therefore, the method according to the embodiment secures at least two position accuracies. One of the position accuracies is position accuracy between the circuit conductors 3a and 3b as the circuit pattern 3A and the other of the position accuracies is position accuracy between the circuit conductors 3a and 3b of the two types of semi-finished products.

When producing the metal base circuit board 1A, a circuit inserting step is performed in order from the circuit conductor 3a having a lower height. In this circuit inserting step, two types of the semi-finished product in which one has the circuit conductors 3a and the other has the circuit conductor 3b are used.

The circuit alignment jig 47 shown in FIG. 13 has the same thickness as the circuit conductor 3b or the thickness being thinner than the thickness of the circuit conductor 3b. According to the second embodiment in FIG. 13, the thickness of the circuit alignment jig 47 is the same as the thickness of the circuit conductor 3b. If the thickness of the circuit alignment jig 47 is thinner than that of the circuit conductor 3b, the lower surface side or lower portion of the circuit conductor 3b is embedded in the insulating layer 7 in the same way as the first embodiment.

In the pressing/heating step S5, a concave/convex pressing tool 49 is used instead of the flat pressing tool 39 of the first embodiment.

The concave/convex pressing tool 49 has pressing convex portions 49a to be respectively inserted and fitted into the pierced portions 47a of the circuit alignment jig 47. The concave/convex pressing tool 49 has a pressing concave portion 49b corresponding to the circuit conductor 3b.

The lower surface of the pressing convex portion 49a and the inner upper surface of the pressing concave portion 49b are formed flat.

The inner upper surface of the pressing concave portion 49b contacts the upper surface of the circuit conductor 3b and the upper surface of the circuit alignment jig 47.

A total dimension of the protrusion dimension of the pressing convex portion 49a and the thickness of the circuit conductor3a is the same as the thickness of the circuit alignment jig 47, or the thickness of the circuit alignment jig 47 is smaller than the total dimension. The thickness of the circuit alignment jig 47 is the same as the thickness of the circuit conductor 3b, or smaller than the thickness of the circuit conductor 3b.

If the thickness of the circuit alignment jig 47 is smaller than the total dimension, and/or if the thickness of the circuit alignment jig 47 is smaller than the thickness of the circuit conductor 3b, the circuit conductors 3a and/or 3b are embedded in the insulating layer 7.

The lower edges of the pierced portions 47a and 47b of the circuit alignment jig 47 may be chamfered in the same way as the first embodiment to form fillets for the circuit conductors 3a and 3b.

Therefore, the second embodiment is provide the same effects as those of the first embodiment.

Further, in the present embodiment, the circuit conductors 3a and 3b having the different heights are securely bonded and held to the insulating layer 7.

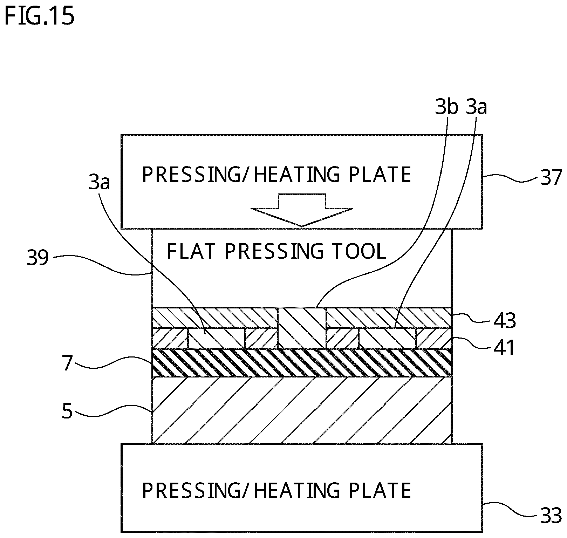

FIG. 14 is a conceptual explanatory view showing an order of superposing circuit alignment jigs in a circuit inserting step of a producing method according to the third embodiment of the present invention. FIG. 15 is a conceptual explanatory view illustrating a pressing/heating step of the producing method. to the present embodiment refers to FIG. 12 as a cross-sectional view of a metal base circuit board provided with circuit pattern with different heights.

The producing method according to the third embodiment employs superposing circuit alignment jigs 41 and 43 for circuit conductors 3a and 3b having different heights or thicknesses in the circuit inserting step S4.

As shown in FIGs. 14 and 15, the circuit alignment jigs 41 and 43 are provided according to the circuit conductors 3a and 3b. The circuit alignment jig 41 includes three pierced portions 41a and 41b according to the circuit conductors 3a and 3b. The circuit alignment jig 43 has one pierced portion 43b corresponding to the circuit conductor 3b.

When the circuit conductors 3a and 3b are inserted into the pieced portions 41a, 41b and 43b in the circuit inserting step S4 in FIG. 14. The circuit alignment jigs 41 and 43 are mounted on an insulating layer 7 in this order. The circuit conductors 3a and 3b are respectively inserted into the pierced portions 41a, 41b and 43b in this order.

As shown with an arrow in FIG. 14, in the circuit inserting step S4, the circuit alignment jig 41 is positioned and arranged on the insulating layer 7 formed on the metal substrate 5. The circuit conductors 3a are inserted into the pierced portions 41a of the positioned circuit alignment jig 41. Then, the circuit alignment jig 43 is positioned and arranged onto the circuit alignment jig 41. The circuit conductor 3b is inserted into the pierced portion 43b and 41b which communicate with each other in the thickness direction. Subsequently, a pressing/heating step S5 in FIG. 15 is performed.

In this embodiment, the individually prepared circuit conductors 3a and 3b are individually inserted into the pierced portions. Namely, the circuit conductors 3a are inserted into the pierced portions 41a of the circuit alignment jig 41, and the circuit conductor 3b is inserted into the pierced portions 41b and 43b of the circuit alignment jigs 41 and 43. In this case, the circuit inserting step S4 does not use the semi-finished product W1 and the extrusion jig 35 that are used in the first embodiment. The circuit inserting step S4 may, however, use the semi-finished product W1 and the extrusion jig 35. And the circuit conductors 3a are individually or respectively inserted into the pierced portions 41a of the circuit alignment jig 41 by the inserting jig. Next, the circuit alignment jig 43 is positioned and arranged onto the circuit alignment jig 41. The circuit conductor 3b is inserted into the pierced portions 43b and 41b. Subsequently, the pressing/heating step S5 in FIG. 15 is performed.

In the pressing/heating step S5 in FIG. 15, the circuit conductors 3a and 3b are pressed and heated together with the circuit alignment jigs 41 and 43 between the pressing/heating plates 33 and 37 via the flat pressing tool 39.

In this case, the thickness of the circuit alignment jig 41 is thinner than the thickness of the circuit conductor 3a. The sum of the thicknesses of the superposed circuit alignment jigs 41 and 43 is thinner than the thickness of the circuit conductor 3b. Thus, the lower surfaces of the circuit conductors 3a and 3b are embedded in the insulating layer 7 as described above.

The pierced portions 41a and 41b of the circuit alignment jig 41 may be chamfered in the same way as the first embodiment, thereby to form fillet-shaped portions for the circuit conductors 3a and 3b.

The third embodiment, therefore, provides the same effect as those of the first embodiment.

Further, in the present embodiment, the circuit conductors 3a and 3b having different heights or thicknesses are securely bonded and held to the insulating layer 7.

## Claims

1. A method for producing a circuit board, the method comprising:
arranging a circuit alignment jig (31) on an insulating layer (7) formed on a metal substrate (5), the circuit alignment jig (31) having a pierced portion (31a) for inserting a circuit conductor (3a) corresponding to a circuit pattern (3);
inserting a circuit conductor (3a) into the pierced portion (31a); and
pressing the circuit conductor (3a) to the insulating layer (7) together with the circuit alignment jig (31).

2. The method for producing the circuit board according to claim 1,
wherein a thickness of the circuit alignment jig (31) is thinner than a thickness of the circuit conductor (3a).

3. The method for producing the circuit board according to claim 2,
wherein the pierced portion (31a) has an enlarged portion on an insulating layer side, the enlarged portion gradually increasing a contour of the pierced portion (31a) toward the insulating layer (7), and
wherein pressing the circuit conductor (3a) to the insulating layer (7) together with the circuit alignment jig (31) comprises partly swelling the insulating layer into the enlarged portion during the pressing.

4. The method for producing the circuit board according to claim 1,
wherein the circuit alignment jig (31) is subjected to surface treatment to secure releasability from the insulating layer (7).

5. The method for producing the circuit board according to claim 1,
wherein inserting a circuit conductor (3a) into the pierced portion (31a) comprises
arranging a semi-finished product (W1) being a plate material that positions and holds the circuit conductor (3a) corresponding to the circuit pattern (3) onto the circuit alignment jig (31), and
extruding the circuit conductor (3a) from the semi-finished product (W1) to conduct the inserting of the circuit conductor (3a) into the pierced portion (31a).
